**Europäisches Patentamt**

**European Patent Office**

**Office européen des brevets**

(11) Veröffentlichungsnummer: **0 237 930**

**A2**

## (12) EUROPÄISCHE PATENTANMELDUNG

(21) Anmeldenummer: 87103470.8

(22) Anmeldetag: 11.03.87

(51) Int. Cl.⁴: **H03F 3/24** , H03F 3/217

(30) Priorität: 17.03.86 DE 3608871

(43) Veröffentlichungstag der Anmeldung:
23.09.87 Patentblatt 87/39

(84) Benannte Vertragsstaaten:
**AT BE CH DE ES FR GB GR IT LI LU NL SE**

(71) Anmelder: **ELAN Elektronische Anlagen GmbH
Hauptstrasse 57
D-6087 Büttelborn 2(DE)**

(72) Erfinder: **Rütt, Winfried Peter
Hauptstrasse 57
D-6087 Büttelborn 2(DE)**

(74) Vertreter: **Patentanwälte Dipl.-Ing. F.W. Möll
Dipl.-Ing. H.Ch. Bitterich
Langstrasse 5 Postfach 2080
D-6740 Landau(DE)**

(54) **Hochfrequenzsender.**

(57) Ein Hochfrequenzsender für sinusförmige Ausgangsleistung enthält einen LC-Parallelschwingkreis (L,C) als Ausgangskreis. An den Ausgangskreis - (L,C) sind eine Mehrzahl von HF-Modulen kleiner Leistung angekoppelt. Jedes HF-Modul besteht aus einem gesteuerten Schalter (S1.1, S1.2), der mit einer λ/4-Leitung (LL1,LL2) beschaltet ist. Die Einkopplung der am Ausgang der λ/4-Leitungen - (LL1,LL2) auftretenden Sinus-Hochfrequenzleistungen auf den Ausganskreis (L,C) erfolgt über einen Koppelkondensator (CK1, CK2) und eine Primärspule (L1, L2). Die Spannungsversorgung - (UB) übernimmt ein getaktetes Schaltnetzteil (1), dem die Netzspannung (2) und ein Sollwert (3) für die Modulation der HF-Ausgangsleistung zugeführt werden. Die Betriebsspannung (UB) wird jedem HF-Modul über einen eigenen Schalter (S2.1, S2.2), einen Glättungskondensator (CL1, CL2) und eine λ/4-Leitung (LL7, LL8) zugeführt. Kurzschlußschalter (SK1, SK2) parallel zu jedem gesteuerten Schalter - (S1.1, S1.2) sorgen bei einem Schalterdefekt dafür, daß der Ausgangskreis (L,C) nur minimal verstimmt wird.

## Hochfrequenzsender

Die Erfindung betrifft einen modulierbaren, fremderregten Hochfrequenzsender für sinusförmige Ausgangsleistung gemäß dem Oberbegriff des Patentanspruchs 1.

Ein im sogenannten F-Betrieb arbeitender Leistungsverstärker ist bekannt aus dem Buch von Kovacs: "Hochfrequenzanwendungen von Halbleiter-Bauelementen", Franzis-Verlag München, 1977, Seite 387. Die bekannte Schaltung besitzt einen im Schalterbetrieb arbeitenden MOS-FET-Transistor, der mit einem $\lambda$/4-Transformator angepaßt ist. Ein auf die Grundfrequenz abgestimmter Parallelschwingkreis am Ausgang schließt die Oberwellen kurz. Infolge des $\lambda$/4-Transformators entsteht am Drainpunkt des Feldeffekttransistors für die geradzahligen Harmonischen ein Kurzschluß und für die ungeradzahligen Harmonischen ein Leerlauf. Wegen des Leerlaufs enthält der Drainstrom keine ungeradzahligen Harmonischen der Grundfrequenz. Die geradzahligen Harmonischen der Grundfrequenz dagegen zirkulieren im Kurzschluß und verbrauchen demzufolge keine Leistung. Hieraus ergibt sich ein sehr hoher Wirkungsgrad der Schaltung, der im Idealfall 100 % beträgt. Im realen Anwendungsfall wird der Wirkungsgrad W der Schaltung reduziert durch das Verhältnis zwischen der Impedanz R der $\lambda$/4-Leitung und dem Einschaltwiderstand $R_{ON}$ des Schalttransistors gemäß der Formel $W_F = R/(R + 2R_{ON})$. Der Wirkungsgrad ist damit um ca. 27 % höher als der eines heute üblicherweise verwendeten Klasse-B-Gegentakt-Leistungsverstärkers.

Daß das bekannte Schaltungsprinzip bis heute keinen praktischen Eingang in die Technik gefunden hat, dürfte mehrere Gründe haben. Ein Grund liegt in der Notwendigkeit, eine $\lambda$/4-Leitung verwenden zu müssen; eine solche Leitung besitzt im technischen Frequenzbereich eine Länge von mehreren Metern. Ein weiterer Grund dürfte im Fehlen ausreichend leistungsstarker Schalttransistoren, insbesondere Feldeffekttransistoren liegen. Ein dritter Grund dürfte darin zu finden sein, daß eine Modulation der Ausgangsleistung nur über die Gleichspannungsversorgung möglich ist, wodurch bei üblicher Technik der Gesamtwirkungsgrad der Schaltung wieder unter den eines Klasse-B-Leistungsverstärkers fällt.

Der vorliegenden Erfindung liegt deshalb die Aufgabe zugrunde, einen Hochfrequenzsender der eingangs genannten Art anzugeben, der die Vorteile des Klasse-F-Leistungsverstärkers beibehält, auf beliebig hohe Leistung erweiterbar ist und mit hohem Wirkungsgrad moduliert werden kann.

Diese Aufgabe wird gelöst durch die kennzeichnenden Merkmale des Patentanspruchs 1.

Die vorliegende Erfindung geht also nicht den naheliegenden Weg, zur Erhöhung der Schaltleistung und zur Verringerung des Einschaltwiderstandes mehrere Schalttransistoren parallel zu schalten; dies würde die Notwendigkeit mit sich bringen, den einzelnen Schalttransistoren zusätzliche Widerstände in Serie zu schalten, um eine gleichmäßige Leistungsaufteilung zu erzielen. Die vorliegende Erfindung geht vielmehr den Weg, einzelne Schaltermodule aus einem Schalter und einer $\lambda$/4-Leitung zu bilden und diese Module dann parallel auf einen Ausgangskreis zu koppeln. Hierbei wird die Impedanz der $\lambda$/4-Leitung zur Leistungsaufteilung und -begrenzung herangezogen. Es ist auf diese Weise sogar möglich, Schaltermodule mit unterschiedlicher Leistungsfähigkeit parallelzuschalten. Dadurch erlaubt diese Modultechnik auch eine besonders schnelle Reparatur im Schadensfall.

Als Gleichspannungsversorgung können mit Vorteil die bekannten getakteten Schaltnetzteile eingesetzt werden. Deren hoher Wirkungsgrad über den gesamten Bereich ist grundsätzlich bekannt. Darüber hinaus hat die Modulation des Hochfrequenzsenders über die Gleichspannungsversorgung den weiteren Vorteil, daß nur bei maximaler Ausgangsleistung die Schalter mit der vollen Spannung belastet werden, während bei der meist verringerten Leistungsabgabe auch die Schalter spannungsmäßig entlastet sind. Dadurch führen beispielsweise auch Fehlanpassungen des Ausgangs selten zu Störungen.

Falls ein spezielles Schaltnetzteil nicht zur Verfügung steht, kann auch ein Konstantspannungsnetzteil herkömmlicher Technik verwendet werden, dem ein getakteter Schalter nachgeschaltet wird, über dessen Ein-Aus-Verhältnis bzw. Schaltfrequenz die Versorgungsgleichspannung modulierbar ist. Die Koppelschaltung zwischen dem getakteten Schalter und dem Hochfrequenzsender erfolgt dann über eine Ladedrossel mit Ladekondensator und Freilaufdiode oder mit einem Ladekondensator.

Darüber hinaus besteht die bevorzugte Möglichkeit, die Koppelschaltung in der Gleichspannungsversorgung mit einer $\lambda$/4-Leitung auszurüsten. Eine solche Leitung transformiert den Hochfrequenzkurzschluß auf der Gleichspannungsseite in einen Leerlauf auf der Wechselspannungsseite, so daß die Hochfrequenz minimal gedämpft wird.

Da im praktischen Betrieb immer damit gerechnet werden muß, daß einer der Schaltermodule beispielsweise durch Zerstörung des Schalttransistors ausfällt, sind Vorsorgen zu treffen, um die Auswirkungen einer solchen Störung möglichst gering zu halten. Zu diesem Zweck wird jedem Schalter die Versorgungsgleichspannung über eine eigene Koppelschaltung zugeführt, wobei vorzugsweise in jeder Gleichspannungskoppelschaltung ein Unterbrecherschalter nach Art einer Sicherung und ein Ladekondensator als Hochfrequenzkurzschluß eingeschaltet sind. Mit diesem Unterbrecherschalter wird also die Gleichspannungsversorgung des defekten Moduls abgeschaltet, während die übrigen, intakten Module weiter arbeiten können.

Bei einem Schalterdefekt sind zwei Zustände möglich: Enweder ist der Schalter dauernd geschlossen oder dauernd offen. Ein Kurzschluß des Schalters wird von der λ/4-Leitung in einen Leerlauf transformiert; der Ausgangskreis wird in diesem Störfall nicht belastet, die Anpassung durch Ausfall der Impedanz der betreffenden λ/4-Leitung nur wenig verstimmt. Ein Offenbleiben des Schalters wird dagegen durch die λ/4-Leitung in einen Kurzschluß am Ausgangskreis transformiert, was zu einer erheblichen Störung auch der übrigen Schaltermodule führen würde. Um dies sicher zu verhindern, wird jedem Schalter ein Kurzschlußschalter parallelgeschaltet, der bei jedem Ausfall des eigentlichen Schalters den erwünschten Kurzschluß am Eingang der λ/4-Leitung erzeugt. Als Kurzschlußschalter eignen sich in den meisten Fällen schnelle mechanische Schalter.

Die Ankopplung der einzelnen Schaltermodule an den Ausgangskreis kann durch einfaches Parallelschalten, beispielsweise über einen gemeinsamen, die Versorgungsgleichspannung sperrenden Koppelkondensator erfolgen. Vorzugsweise jedoch wird jedem Schaltermodul eine eigene Primärwicklung zugeordnet, über die die Leistung transformatorisch auf den dann als Tank-Kreis wirkenden Ausgangskreis gekoppelt wird.

Um die Möglichkeit zur Verringerung des Bauvolumens des Hochfrequenzsenders, was durch Verringerung der Verlustleistung durch Auswahl des Klasse-F-Leistungsverstärkers grundsätzlich möglich ist, nicht wieder zu verspielen, ist auch der Konstruktion des die Leistung der einzelnen Schaltermodule sammelnden und am Ausgang abgebenden Ausgangskreises große Aufmerksamkeit geschenkt worden. Vorzugsweise wird die Induktivität des Ausgangskreises durch ein Leiterstück, beispielsweise ein Stück Kupferrohr, gebildet, über das wenigstens ein Ringkern, z. B. aus Ferrit, geschoben ist. Über diesen Ringkern wird wenigstens eine der Primärwicklungen, die von den einzelnen Schaltermodulen gespeist werden, geschleift.

Der Kondensator im Ausgangskreis sollte zum Ausgleich von Bautoleranzen abstimmbar sein. Zu diesem Zweck wird der Kondensator gebildet durch eine erste Metallplatte, die mit dem einen Ende des Leiterstücks verbunden ist, und eine Genplatte, die gegenüber der ersten Platte isoliert ist, wobei die Kapazität der beiden Platten beispielsweise durch Verändern des Abstandes oder durch Einschieben von Isoliermaterialien mit einer hohen Dielektrizitätskonstante bzw. einer isolierten Metallplatte einstellbar ist.

Die eine der beiden Metallplatten kann gleichzeitig als Grundplatte dienen und mit dem Bezugspotential der Schaltung verbunden sein. Es ist dann auch möglich, unter Verwendung dieser Platte einen Abschirmkäfig um den Ausgangskreis zu errichten.

In einer abgewandelten Ausführungsform der Erfindung wirkt der Abschirmkäfig gleichzeitig als Teil der Induktivität. Zu diesem Zweck wird im Inneren eines metallischen Gehäuses ein Leiterstück montiert, wobei dieses auf der einen Seite mit dem Gehäuse, auf der anderen Seite mit einer der Metallplatten des Schwingkreiskondensators verbunden ist. Auch auf dieses Leiterstück werden dann Ferrit-Ringkerne geschoben zur Erzeugung der erforderlichen Schwingkreisinduktivität und zum Einkoppeln der elektrischen Teilleistungen.

Für den Fall, daß eine Vielzahl von Schaltermodulen vorhanden ist und deshalb eine übergroße Baulänge des Ausgangskreises erforderlich würde, ist es möglich, im Inneren des Gehäuses mehrere parallele Leiterstücke vorzusehen und auf jedes Leiterstück einen oder mehrere Schaltermodule arbeiten zu lassen. Die so eingekoppelte elektrische Leistung wird dann in dem für alle Leiterstücke als gemeinsamer Rückleiter dienenden Gehäuse summiert.

Um auch bei einer solchen Bauart die elektrische Leistung mit der erforderlichen Impedanz auskoppeln zu können, ist eine Anzapfung aller parallelen Leiterstücke erforderlich. Diese wird vorzugsweise durch einen in einer vorbestimmten Ebene angeordneten gemeinsamen Koppelleiter realisiert.

Zur Verringerung der Baugröße des Hochfrequenzsenders muß jedoch nicht nur die Baugröße des Ausgangskreises möglichst klein gehalten werden, sondern auch die Baugröße der λ/4-Leitungen. Zu diesem Zweck wurde eine extrem kurze und kleinbauende Konstruktion entwickelt, die aus einem geschlitzten Kupferrohr besteht, auf das eine Wicklung isoliert aufgewickelt ist. Eine solche Konstruktion erlaubt eine Verkürzung der mechanischen Leitungslänge gegenüber herkömmlichen Leitungen um etwa den Faktor 100.

Vorzugsweise kann im Kupferrohr ein Abgleichkern vorgesehen sein, um die elektrische Länge der λ/4-Leitung noch fein justieren zu können.

Aufgrund der geringen Baugröße ist es im übrigen möglich geworden, auch die λ/4-Leitungen in das Abschirmgehäuse des Ausgangskreises einzubauen. Dadurch kann etwaige Störstrahlung schon von vornherein weitgehend reduziert werden.

Gemäß einer vorteilhaften Weiterbildung der Erfindung beträgt die elektrische Länge der Leitung ein ungeradzahliges Vielfaches von λ/4. Dadurch ist es möglich, die Frequenz des Hochfrequenzsenders in bestimmten Stufen umzuschalten, ohne die Anpassungsleitung ebenfalls umschalten zu müssen. Ein solcher Hochfrequenzsender ist deshalb problemlos vom Mittelfrequenzbereich bis zum Hochfrequenzbereich einsetzbar. Im übrigen ist es ohne große Probleme möglich, die Frequenz um ca. +/- 10 % gegenüber der Grundfrequenz des Ausgangschwingkreises stufenlos zu variieren.

Als Schalter sind nicht nur wie in der eingangs genannten Literaturstelle vorgeschlagen Feldeffekttransistoren verwendbar, sondern auch mechanische Schalter, beispielsweise bei Frequenzen bis ca. 50 Kilohertz sogenannte Reedschalter, oder auch Elektronenröhren, diese bis zu den höchsten Frequenzen.

Wie schon eingangs erwähnt, reduziert bei der Verwendung von Feldeffekttransistoren deren relativ hoher Einschaltwiderstand $R_{ON}$ den elektrischen Wirkungsgrad der Schaltung. Gemäß einer vorteilhaften Weiterbildung der Erfindung wird deshalb den Feldeffekttransistoren ein bipolarer Transistor parallelgeschaltet, der im eingeschalteten Zustand den Einschaltwiderstand $R_{ON}$ erheblich reduziert.

Soll die Einheit aus Schalter und/oder λ/4-Leitung als Modul beliebig austauschbar sein, muß ein solches Modul normierte Schnittstellenwerte besitzen. Halbleiterschalter besitzen jedoch üblicherweise relativ stark streuende Parallelkapazitäten. Aus diesem Grund wird jedem Transistor vorzugsweise ein Normierungskondensator parallelgeschaltet, mit dessen Hilfe alle Module auf konstante Kapazitätswerte abgeglichen werden können.

Erfolgt die Ansteuerung der Schalttransistoren mittels Sinusspannung, so führt die hohe Eingangskapazität speziell von MOS-FET-Transistoren zu einem erheblichen Leistungsbedarf. Um hier Verbesserungen zu schaffen, wird der Eingang jedes Transistors mit einer Klemmdiode beschaltet.

Vorzugsweise werden mit einer Sinus-Steuerspannung zwei Transistoren im Gegentakt angesteuert, deren Ausgänge über je eine /4-Leitung auf einen Gegentakt-Übertrager geschaltet sind. Auf diese Weise können beide Halbwellen der Steuerspannung ausgenützt werden.

Falls eine solche Gegentaktschaltung nicht gewünscht ist, wird der eine Transistor durch einen Ersatzkondensator ersetzt, der dann ebenfalls wieder mit einer Klemmdiode beschaltet ist, um die Symmetrie nicht zu stören. Dies ist besonders dann von großer Bedeutung, wenn der Ansteuertransformator mit der Gate-Source Kapazität, der Normierungskapazität und einem weiteren Resonanzkondensator in Resonanz gebracht wird, um auf diese Weise die Steuerleistung zu reduzieren.

Anhand der Zeichnung soll die Erfindung in Form von Ausführungsbeispielen näher erläutert werden. Es zeigen

Fig. 1 eine erste Schaltungsanordnung für einen modulierbaren, fremderregten Hochfrequenzsender mit sinusförmiger Ausgangsspannung,

Fig. 2 eine zweite Schaltungsanordnung,

Fig. 3 eine Schaltungsanordnung für einen Schalter mit einem Feldeffekttransistor,

Fig. 4 eine weitere Schaltungsanordnung für einen Schalter mit zwei im Gegentakt angesteuerten Feldeffekttransistoren,

Fig. 5 eine schematische Ansicht einer /4-Leitung und

Fig. 6 eine schematische Ansicht eines LC-Ausgangskreises.

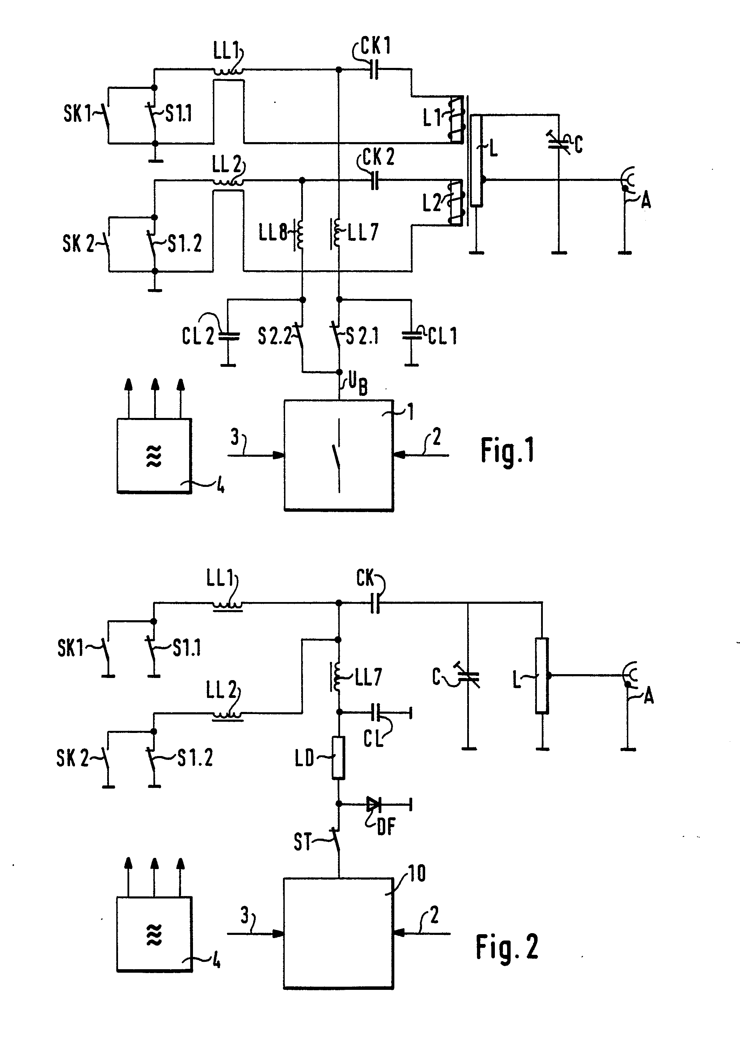

In Fig. 1 erkennt man eine Schaltungsanordnung mit zwei Schaltermodulen. Jeder Schaltermodul besteht aus dem eigentlichen, gesteuerten Schalter S1.1, S1.2, einer λ/4-Leitung LL1, LL2, einem Koppelkondensator CK1, CK2 und einer Primärwicklung L1, L2 zum Einkoppeln der elektrischen Leistung auf die Induktivität L des Ausgangskreises LC. Die Kapazität C des Ausgangskreises LC ist auf die Grundfrequenz abstimmbar. Am Ausgang A steht die gesamte elektrische Leistung aller Schaltermodule zur Verfügung.

Ein Oszillator 4 erzeugt die Ansteuerleistung für die Schalter S1.1, S1.2. Jedem Schalter S1.1, S1.2 ist ein Kurzschlußschalter SK1, SK2 parallelgeschaltet, der bei einer Störung des ihm zugeordneten Schalters geschlossen wird. Die Kurzschlußschalter können vorzugsweise als - schnelle mechanische Schalter ausgebildet sein, auch wenn die Schalter S1.1, S1.2 selbst als Halbleiterschalter oder Elektronenröhren ausgebildet sind.

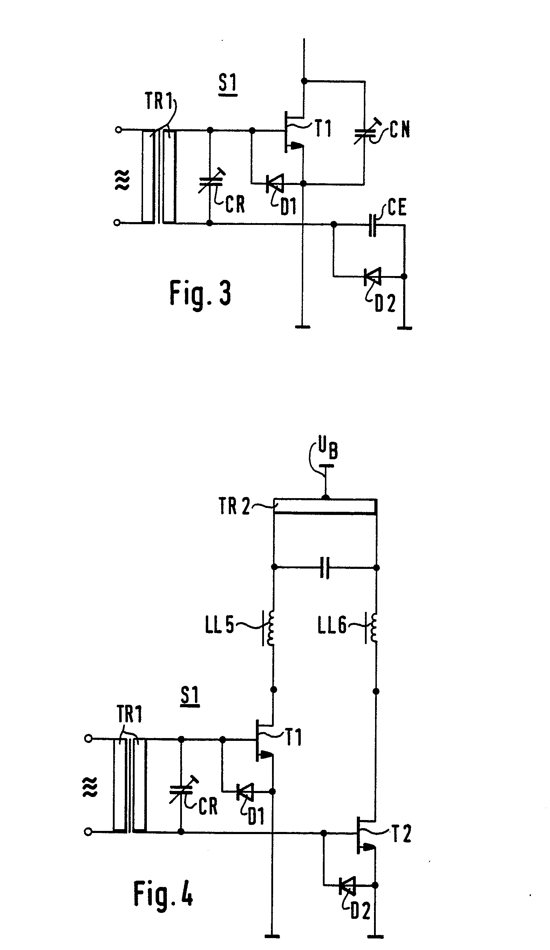

Die Gleichspannungsversorgung erfolgt durch ein getaktetes Schaltnetzteil 1, dem die Netzspannung 2 und der Sollwert 3 für die Modulation der Hochfrequenzleistung zugeführt werden. Die Gleichspannung wird über je einen als Sicherung wirkenden Schalter S2.1, S2.2 und je eine weitere λ/4-Leitung LL7, LL8 eingespeist. Die Einspeisung der Versorgungsspannung UB ist nicht nur wie in der Fig. 2 dargestellt zwischen Koppelkondensator CK und λ/4-Leitung LL, sondern auch direkt an die Schalter S1 möglich.

Im Störfall, beispielsweise bei einer Beschädigung eines der Schalter S1, wird der zugehörige Sicherungsschalter S2 geöffnet und der zugehörige Kurzschlußschalter SK geschlossen. Die λ/4-Leitung LL transformiert den Kurzschluß des Kurzschlußschalters SK in einen Leerlauf am Ausgang, so daß der Ausgangskreis LC dadurch nicht mehr belastet wird. Die geringe Verstimmung der Anpassung durch das Hochohmigwerden der unwirksam gemachten λ/4-Leitung ist um so mehr tolerierbar, je mehr Schaltmodule auf den Ausgangskreis LC arbeiten.

Fig. 2 zeigt eine etwas abgewandelte Schaltungsanordnung. Hier sind die Schaltmodule gleichspannungsmäßig zusammengekoppelt und speisen ihre elektrische Leistung über einen gemeinsamen Koppelkondensator CK in den Ausgangskreis LC. Eine derartige gleichstrommäßige Parallelschaltung ist ohne weiteres möglich, da die Impedanz der λ/4-Leitungen LL1, LL2 für die gewünschte und erforderliche verlustfreie Aufteilung der Leistung auf die einzelnen Schalter S1.1, S1.2 sorgt.

Bei dieser Ausführungsform ist ein nicht getaktetes Konstantspannungsnetzteil 10 eingesetzt. Um dennoch die Hochfrequenz-Ausgangsleistung ohne Reduzierung des Wirkungsgrades variieren zu können, ist zwischen das Netzteil 10 und den Hochfrequenzsender ein getakteter Schalter ST gelegt, dessen Ein-Aus-Verhältnis bzw. Taktfrequenz die gewünschte Modulation erzeugt. Für eine einwandfreie Funktion der Schaltung ist die Koppelschaltung zum Hochfrequenzsender mit einer Ladedrossel LD, einem Ladekondensator CL und einer Freilaufdiode DF ausgerüstet.

Fig. 3 zeigt eine mögliche Ausführungsform für den Schalter S1. Die vom Oszillator 4 erzeugte Steuerspannung wird über einen Transformator TR1 übertragen. Der eine Pol des Transformators TR1 ist mit dem Gate eines Feldeffekttransistors T1 direkt verbunden, während der andere Pol auf eine Ersatzkapazität CE geführt ist. Diese Ersatzkapazität CE bildet die Gate-Kapazität des Transistors T1 nach. Klemmdioden D1, D2 am Gate des Transistors T1 und am Ersatzkondensator CE reduzieren die unerwünschte Aufladung insbesondere der Gate-Kapazität während der Sperrphase des Transistors T1.

Bemerkenswert ist noch der parallel zum Transistor TR1 geschaltete Normierungskondensator CN. Mit Hilfe dieses Normierungskondensators CN kann die Gesamtkapazität jedes Moduls abgeglichen werden, was die Transistormodule frei austauschbar macht. Mit dem Resonanzkondensator CR wird der Steuerkreis abgeglichen.

In Fig. 4 ist eine Gegentakt-Schaltung dargestellt, mit der beide Halbwellen der über den Eingangstransformator TR1 übertragenen Sinus-Steuerspannung ausgenützt werden. Die beiden Transistoren T1, T2 werden abwechselnd ein-und ausgeschaltet. Ihre Ausgänge sind über je eine λ/4-Leitung LL5, LL6 auf die Primärwicklung eines Gegentaktübertragers TR2 geschaltet. An dessen Mittelanzapfung wird die Versorgungsgleichspannung UB eingespeist.

Da die Hochfrequenz-Ausgangsleistung nur von der Versorgungsgleichspannung UB abhängt, stehen die Schalter S1 bzw. die darin verwendeten elektronischen Bauteile, beispielsweise Transistoren T1, T2, nur dann unter der vollen Spannungsbelastung, wenn die maximale Ausgangsleistung verlangt wird. Da die Geräte jedoch überwiegend nur mit verringerter Leistung betrieben werden, ergibt sich eine erhöhte Schonung der elektronischen Bauteile.

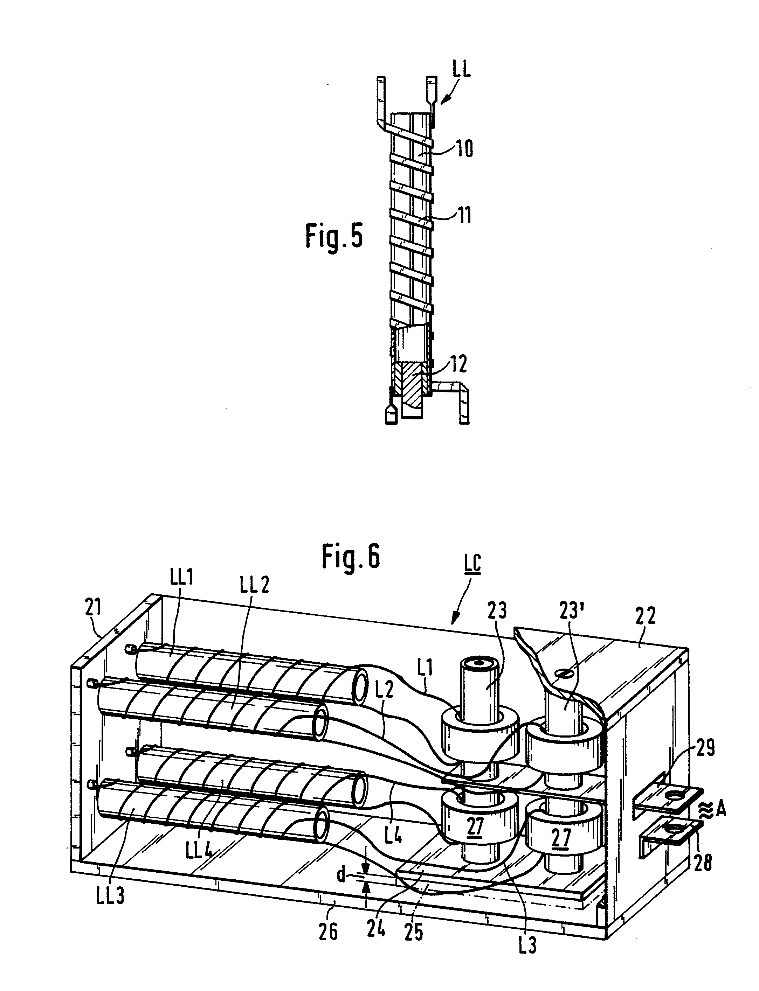

Fig. 5 zeigt die Konstruktion einer λ/4-Leitung extremer mechanischer Kürze. Man erkennt ein Kupferrohr 10, das zur Erhöhung der Güte geschlitzt ist. Auf das Kupferrohr 10 ist eine isolierte Wicklung 11 aufgewickelt. An einem Ende des Kupferrohrs 10 erkennt man einen Abgleichkern 12, mit dem die elektrische Länge der λ/4-Leitung fein justiert werden kann. Bei einer praktisch ausgeführten Leitung dieser Art konnte deren Länge bei einer Frequenz von ca. 14 Megahertz auf weniger als 9 cm reduziert werden, während die λ/4-Wellenlänge im Vakuum über 5 m beträgt. Da über jede λ/4-Leitung Leistungen von einigen 100 Watt fließen, je nach Schaltleistung des eingesetzten Leistungsschalters, kann die Baugröße nicht beliebig verkleinert werden.

Fig. 6 schließlich zeigt eine mögliche Ausführungsform des Ausgangskreises LC. Man erkennt ein quaderförmiges Gehäuse 21, in dem beispielsweise vier λ/4-Leitungen LL1 ... LL4 angeordnet sind. Ferner erkennt man zwei parallele Leiterstücke 23, 23', die an ihrem oberen Ende mit dem Deckel 22 des Gehäuses 21 verbunden sind. Das untere Ende der Leiterstücke 23, 23' ist mit einer Metallplatte 24 verbunden, die vom Boden 26 des Gehäuses 21 einen Abstand d besitzt. Metallplatte 24 und Boden 26 wirken als Kondensator, wobei zum Abgleich der Kapazität entweder der Abstand d variiert oder in den Spalt 25 ein Material mit hoher Dielektrizitätskonstanten oder eine isolierte Metallplatte mehr oder weniger weit eingeschoben wird.

Auf die parallelen Leiterstücke 23, 23' sind Ferrit-Ringkerne 27 aufgeschoben. Über diese sind die Primärwicklungen L1...L4 geschleift, die mit den Enden der λ/4-Leitungen LL1...LL4 direkt verbunden sind. Über die Primärwicklungen wird die von den Schaltermodulen kommende elektrische Leistung auf den Ausgangskreis LC gekoppelt.

Bei dieser Ausführungsform wirkt das Gehäuse 21, 22, 26 als gemeinsamer Rückleiter für die beiden parallelen Leiterstücke 23, 23'.

Um die im Ausgangskreis LC gesammelte elektrische Leistung von den beiden parallelen Leiterstücken 23, 23' mit gleicher Impedanz und gleicher Stärke abnehmen zu können, ist in einer der gewünschten Impedanz entsprechenden Höhe ein Koppelblech 29 angeordnet und aus dem Gehäuse 21 herausgeführt. Der Gegenpol ist als Winkelblech 28 an der Außenseite des Gehäuses 21 angebracht. Falls andere Impedanzwerte erlaubt sind, kann die Ausgangsspannung A beispielsweise auch direkt zwischen der Kondensatorplatte 24 und der Grundplatte 26 abgegriffen werden.

In allen Fällen ist es möglich, das Gehäuse 21 gleichspannungsmäßig auf Masse zu legen. Außerdem wirkt es als Abschirmung zur Verringerung etwaiger Störstrahlung.

Obwohl grundsätzlich auch eine andere mechanische Ausführung des Ausgangskreises LC möglich ist, hat sich eine Ausführungsform mit praktisch geraden Leitungsstücken 23, 23' und aufgeschobenen Ringkernen 27 als optimal hinsichtlich einer Verkleinerung der Bauform erwiesen. Insbesondere ist es bei dieser Konstruktion möglich, eine fast beliebige Anzahl von Schaltmodulen transformatorisch an den Ausgangskreis zu koppeln. Dadurch läßt sich die am Ausgang A abnehmbare Leistung praktisch beliebig erhöhen, ohne daß teure Spezialelemente, insbesondere teure Hochleistungstransistoren, verwendet werden müssen.

**Ansprüche**

1. Modulierbarer, fremderregter Hochfrequenzsender für sinusförmige Ausgangsleistung, enthaltend einen LC-Parallelschwingkreis als Ausgangskreis, einen an diesen über eine $\lambda/4$-Leitung und einen Koppelkondensator angekoppelten elektrischen bzw. elektronischen Schalter und eine Gleichspannungsversorgung mit einer die Wechselspannung sperrenden Koppelschaltung, dadurch gekennzeichnet, daß eine Mehrzahl von Schaltern - (S1.1, S1.2) über je eine eigene Leitung (LL1, LL2) an den Ausgangskreis (L, C) angekoppelt ist, und daß die Gleichspannungsversorgung ein verlustarmes, getaktetes Schaltnetzteil (1) ist.

2. Hochfrequenzsender nach Anspruch 1, dadurch gekennzeichnet, daß die Gleichspannungsversorgung ein Konstantspannungsnetzteil (10) ist, dem wenigstens ein getakteter Schalter (ST) nachgeschaltet ist, über dessen Ein-Aus-Verhältnis bzw. über dessen Taktfrequenz die Versorgungsgleichspannung (UB) moduliert wird, und daß die Koppelschaltung eine Ladedrossel (LD), einen Ladekondensator (LC) und eine Freilaufdiode (DF) umfaßt.

3. Hochfrequenzsender nach Anspruch 1 oder 2, dadurch gekennzeichnet, daß die Koppelschaltung in der Gleichspannungsversorgung eine $\lambda/4$-Leitung (LL 7, LL 8) umfaßt.

4. Hochfrequenzsender nach wenigstens einem der Ansprüche 1 bis 3, dadurch gekennzeichnet, daß jedem Schalter (S1.1, S1.2) die Versorgungsgleichspannung (UB) über eine eigene Koppelschaltung zugeführt ist und daß jeder Koppelschaltung ein Unterbrecherschalter (S2.1, S2.2) und ein Ladekondensator (CL1, CL2) zugeordnet sind.

5. Hochfrequenzsender nach wenigstens einem der Ansprüche 1 bis 4, dadurch gekennzeichnet, daß jedem Schalter (S1.1, S1.2) ein Kurzschlußschalter (SK1, SK2) parallelgeschaltet ist.

6. Hochfrequenzsender nach wenigstens einem der Ansprüche 1 bis 7, dadurch gekennzeichnet, daß die Induktivität (L) des Ausgangskreises durch ein Leiterstück (23) gebildet ist, über das wenigstens ein Ringkern (27) geschoben ist, und daß wenigstens eine der Primärwicklungen (L1, L2) über einen der Ringkerne (27) geschleift ist.

7. Hochfrequenzsender nach Anspruch 6, dadurch gekennzeichnet, daß das Leiterstück U-förmig gebogen ist, wobei der eine Schenkel mit einer ersten Metallplatte (24), der andere Schenkel mit einer zweiten Metallplatte (26) verbunden ist und beide Metallplatten (24, 26) den Kondensator - (C) des Ausgangskreises (L, C) bilden, und daß ein metallisches Gehäuse (21) vorgesehen ist, das das Leiterstück (23) umgibt und einen Teil der Induktivität (L) und die zweite Metallplatte (26) des Kondensators (C) des Ausgangskreises (L, C) bildet.

8. Hochfrequenzsender nach Anspruch 7, dadurch gekennzeichnet, daß mehrere parallele Leiterstücke (23, 23') vorgesehen sind, die gegebenenfalls in einer vorbestimmten Ebene über einen gemeinsamen Koppelleiter (29) angezapft sind.

9. Hochfrequenzsender nach wenigstens einem der Ansprüche 1 bis 8, dadurch gekennzeichnet, daß die Leitung (LL1... LL8) aus einem geschlitzten Kupferrohr (10) besteht, auf das eine Wicklung - (11) isoliert aufgewickelt ist und in dem gegebenenfalls ein Abgleichkern (12) vorgesehen ist.

10. Hochfrequenzsender nach wenigstens einem der Ansprüche 1 bis 9, dadurch gekennzeichnet, daß die Schalter (S1.1, S1.2) mechanische Reedschalter, Elektronenröhren, Transistoren, vorzugsweise FET-bzw. MOS-FET-Transistoren (T1, T2), diese gegebenenfalls in Parallelschaltung, mit Bipolartransistoren sind.

11. Hochfrequenzsender nach Anspruch 10, dadurch gekennzeichnet, daß jedem Transistor (T1, T2) bzw. jeder Parallelschaltung von Transistoren ein Normierungskondensator (CN) parallel geschaltet ist.

12. Hochfrequenzsender nach Anspruch 10 oder 11, dadurch gekennzeichnet, daß zwei Transistoren (T1, T2) im Gegentakt angesteuert sind und ihre Ausgänge über je eine $\lambda/4$-Leitung (LL5, LL6) auf einen Gegentakt-Übertrager (TR2) geschaltet sind.

13. Hochfrequenzsender nach wenigstens einem der Ansprüche 10 bis 12, dadurch gekennzeichnet, daß zur Ansteuerung der Schalter (S1.1, S1.2) ein Steuertransformator (TR1) vorgesehen ist, dessen Sekundärwicklung einerseits auf den Eingang des Schalttransistors (T1), andererseits auf eine entsprechende Ersatzschaltung mit Ersatzkondensator (CE) und Klemmdiode (D2) geschaltet ist.

14. Hochfrequenzsender nach wenigstens einem der Ansprüche 1 bis 13, dadurch gekennzeichnet, daß die Frequenz zur Ansteuerung der Schalter (S1.1, S1.2) und der Ausgangskreis (L, C) umschaltbar sind und daß die elektrische Länge der Leitungen (LL1 ... LL8) dabei jeweils ein ungeradzahliges Vielfaches von λ/4 beträgt.

Fig.1

Fig. 2

Fig. 3

Fig. 4

# Fig.5

LL

10

11

12

# Fig.6

LC

LL1
LL2
L1
23
23'
22
21
L2
29
≈ A
L4
27
27
28
d
LL4
26
24
25
L3
LL3